# FASCICULE DE BREVET EUROPEEN

(11) **EP 0 347 727 B1**
(45) Date de publication et mention de la délivrance du brevet: **18.11.1993**
(21) Numéro de dépôt: 89110731.0
(22) Date de dépôt: 14.06.1989
(51) Int. Cl.: C23C 14/34, C23C 14/06

(54) **Procédé de dépôt d'un revêtement de couleur noire sur un substrat et revêtement de couleur noire obtenu par ce procédé**
Verfahren zum Aufbringen einer schwarzen Beschichtung auf ein Substrat, sowie dadurch erhaltene schwarze Beschichtung
Process for deposition of a black coating on a substrate and black coating obtained by the process

(30) Priorité: 24.06.1988 CH 2434/88
(43) Date de publication de la demande: 27.12.1989
(73) Titulaire: ASULAB S.A., CH-2502 Bienne (CH)
(72) Inventeur: Luthier, Roland, CH-1006 Lasanne (CH); Lévy, Francis, CH-1025 Saint-Sulpice (CH); Mocellin, Alain, CH-1052 Le Mont-sur-Lausanne (CH)
(74) Mandataire: de Montmollin, Henri

(56) Documents cités:
- DE-A- 3 728 837
- FR-A- 2 128 858
- FR-A- 2 592 063
- GB-A- 2 182 950

## Description

On désire souvent déposer un revêtement de couleur noire sur un substrat constitué par un objet ayant principalement ou accessoirement une fonction décorative tel qu'un élément de boîte ou de bracelet de montre.

Un tel revêtement doit en général être opaque de manière que la couleur du substrat sur lequel il est déposé ne modifie pas sa propre couleur noire, parfaitement bien adhérer à ce substrat et résister à l'usure et à la corrosion, ou tout au moins à l'oxydation.

Il existe divers procédés permettant de déposer un tel revêtement.

Ainsi, par exemple, la demande de brevet FR-A-2 592 063 décrit la formation d'un revêtement noir sur un substrat disposé dans une enceinte adéquate par un procédé de déposition en phase vapeur de titane avec adjonction de divers éléments gazeux qui sont introduits successivement dans l'enceinte de manière à former plusieurs couches superposées ayant des compositions différentes.

La demande de brevet FR-A-2 592 882 décrit un autre procédé, du même genre que le précédent, utilisant comme matière de base un alliage dur de titane et comprenant l'adjonction dans l'enceinte de divers éléments gazeux en proportions déterminées.

Le brevet US-A-4,634,635 décrit un autre procédé selon lequel le revêtement noir, qui ne comporte aucun élément métallique, est déposé sur le substrat à température élevée, à l'aide d'un procédé chimique en phase vapeur.

Ces procédés connus ne se prêtent pas bien à une utilisation industrielle, car ils ont en commun le fait que la couche qu'ils permettent de déposer est constituée, en partie tout au moins, de l'un ou de plusieurs des éléments chimiques présents sous forme de gaz ou de vapeur dans l'enceinte.

La composition chimique de cette couche peut donc être assez variable, car elle dépend directement de la concentration de cet élément, ou de ces éléments dans ce gaz ou cette vapeur, concentration qu'il est très difficile de régler exactement et de maintenir absolument constante pendant tout l'opération de dépôt qui peut durer plusieurs heures.

Un but de la présente invention est de proposer un procédé de dépôt d'un revêtement de couleur noire sur un substrat qui est plus facile à mettre en oeuvre industriellement que les procédés connus, la composition chimique de ce revêtement étant en outre parfaitement et facilement déterminée à l'avance.

Ce but est atteint par le procédé revendiqué, qui est caractérisé par le fait qu'il comprend la préparation d'une matière solide comportant du titane, de l'aluminium, de l'oxygène et de l'azote et une opération de pulvérisation cathodique utilisant une cible en ladite matière, ladite pulvérisation cathodique étant réalisée en présence dudit substrat et sous une atmosphère de gaz non réactif.

Un autre but de la présente invention est de proposer un revêtement opaque ayant une belle couleur noire, profonde et brillante, qui est facile à déposer sur un substrat de manière industrielle, qui adhère très bien sur ce substrat, et qui a une bonne résistance à l'usure et à la corrosion.

Ce but est atteint par le revêtement revendiqué, qui est caractérisé par le fait qu'il comporte du titane, de l'aluminium, de l'oxygène et de l'azote.

Les techniques de pulvérisation cathodiques sont bien connues et ne seront pas décrites en détail ici. Il suffit de rappeler que, selon ces techniques, le substrat qui doit être recouvert d'une couche est fixé dans une enceinte étanche, en regard et à proximité d'une cible comportant généralement au moins une partie des éléments destinés à former la couche.

Après que la cible et le substrat ont été fixés sur leurs supports, l'enceinte est fermée et vidée, au moins partiellement, de l'air qui la remplit. Cette enceinte est ensuite remplie d'un gaz à une pression déterminée.

Une tension continue ou alternative est ensuite appliquée entre le substrat et la cible, de manière qu'un arc électrique s'amorce et se maintienne entre cette cible et ce substrat.

Si cette tension appliquée entre le substrat et la cible est continue, cette dernière doit être en un matériau électrique conducteur.

Par contre, si cette tension est alternative, la cible peut également être en un matériau électriquement isolant.

Dans les deux cas, l'arc électrique amorcé et entrenu par cette tension ionise le gaz qu'il traverse, et les ions ainsi produits bombardent violemment la cible et lui arrachent des atomes ou des molécules qui se déposent ensuite sur le substrat.

Si nécessaire, le substrat est maintenu à une température déterminée par un fluide de refroidissement qui circule dans son support.

Il faut noter que l'utilisation d'une cible en un matériau électriquement conducteur présente un avantage technique indéniable car l'appareillage qui doit être utilisé pour réaliser une pulvérisation cathodique sous tension continue est nettement plus simple que celui qui doit être utilisé lorsque cette tension est alternative.

Le procédé de dépôt objet de la présente invention comporte une opération de pulvérisation cathodique telle que celle qui a été décrite succinctement ci-dessus, et son originalité réside dans le fait que la cible utilisée pendant cette opération comporte tous les éléments qui doivent former la couche que l'on désire déposer, à savoir du titane, de l'aluminium, de l'oxygène et de l'azote, dans des proportions qui seront précisées plus loin.

Le gaz présent dans l'enceinte pendant la pulvérisation cathodique ne doit donc pas réagir chimiquement avec ces éléments, et sa nature et sa pression n'influencent pas la composition chimique de la couche déposée. Ce gaz peut donc être un gaz neutre, par exemple, de l'argon ou du néon.

La matière de la cible mentionnée ci-dessus peut être préparée de plusieurs manières.

On peut, par exemple, mélanger une poudre d'oxyde de titane TiO2 et une poudre de nitrure d'aluminium AlN dans un rapport molaire de 1,5 TiO2 pour 2 AlN, et réaliser une opération de frittage de ce mélange en le soumettant pendant une heure environ à une température de 1'400°C environ et à une pression de 45 Mégapascals environ.

Au cours de ce frittage, il se produit une réaction d'échange selon la formule :

1,5 TiO2 + 2 AlN → Al203 + 1,5 TiN + 0,25 N2.

La matière résultant de cette opération de frittage est solide, et elle a une structure métallographique présentant des grains très fins. En outre, cette matière est électriquement conductrice, grâce au fait qu'elle comporte du nitrure de titane TiN.

La matière de la cible mentionnée ci-dessus peut également être préparée en mélangeant une poudre de nitrure de titane TiN et une poudre d'oxyde d'aluminium Al203 dans un rapport molaire de 1,5 TiN pour 1 Al203, et en soumettant ce mélange à une opération de frittage dans les mêmes conditions que dans le premier exemple ci-dessus.

Ce frittage n'est pas réactif, et la matière solide qui en résulte a une structure métallographique présentant des grains légèrement plus gros que dans l'exemple précédent. Cette matière comprenant du nitrure de titane TiN, elle est également conductrice.

Il faut noter que, dans les deux exemples mentionnés ci-dessus, il est préférable, mais non obligatoire, de choisir des quantités de poudre et de réaliser les opérations de frittage de manière que le corps solide obtenu ait directement la forme et les dimensions que doit avoir la cible utilisée pendant l'opération de pulvérisation cathodique.

Une autre manière de préparer la matière de la cible mentionnée ci-dessus consiste à simplement mélanger une poudre d'oxyde de titane TiO2 et une poudre de nitrure d'aluminium AlN dans les mêmes proportions que dans le premier exemple ci-dessus.

La matière résultant de ce simple mélange de poudres n'est évidemment pas solide et, pour l'utiliser comme cible pendant l'opération de pulvérisation cathodique, il faut la verser dans un récipient adéquat qui sera disposé dans l'enceinte où sera réalisée cette pulvérisation cathodique. Après que cette matière a été versée dans ce récipient, elle est de préférence comprimée, à froid, pour augmenter sa densité apparente et pour que sa surface supérieure, qui sera bombardée par les ions pendant la pulvérisation cathodique, soit aussi plane que possible.

Contrairement aux deux précédentes, la matière préparée de la manière qui vient d'être décrite est isolante car elle ne comporte pas de nitrure de titane TiN.

La déposante a constaté que lorsqu'une cible faite de l'une des matières décrites ci-dessus est utilisée dans une opération de pulvérisation cathodique, il se forme sur le substrat placé dans l'enceinte de pulvérisation une couche opaque ayant une belle couleur noire, brillante, cette couche étant en outre dure, résistante à l'usure et à la corrosion, et électriquement conductrice.

Les conditions dans lesquelles cette pulvérisation cathodique doit être réalisée ne sont pas très critiques. On trouvera ci-après une exemple pratique et non limitatif de ces conditions, dans un cas où le substrat sur lequel la couche est déposée est en acier inoxydable et où la cible utilisée a été fabriquée selon la première méthode décrite ci-dessus, c'est-à-dire par frittage réactif d'un mélange de poudres d'oxyde de titane TiO2 et de nitrure d'aluminium AlN.
- Pression résiduelle dans l'enceinte avant l'introduction du gaz: moins de 3 x 10⁻² Pa (3. 10⁻⁶ millibar);
- Gaz introduit dans l'enceinte: Argon pur à 99,999%, sous une pression de 4 Pa (4. 10⁻² millibar);
- Tension appliquée entre la cible et le substrat: alternative, amplitude de 1200 V crête à crête, fréquence de 13,56 MHz;
- Diamètre de la cible: 85 mm;
- Distance entre la cible et le substrat: 70 mm;
- Puissance électrique absorbée pendant la pulvérisation: 350 W
- Température du substrat: maintenue à 20°c pendant toute l'opération de pulvérisation.

En outre, avant l'opération de pulvérisation cathodique proprement dite, le substrat en acier inoxydable a été décapé, de manière classique, en lui appliquant pendant 10 minutes une tension négative par rapport à celle de la cible, de manière à établir une décharge électrique absorbant une puissance de 90 W.

Dans ces conditions, l'épaisseur de la couche déposée sur le substrat augmente à une vitesse de 9 nm par minute environ.

L'analyse de cette couche à l'aide d'une microsonde électronique a montré qu'elle comporte les quatre éléments chimiques présents dans la cible, à savoir le titane, l'aluminium, l'oxygène et l'azote.

La concentration atomique de ces éléments, mesurée lors de cette analyse, est la suivante:

| | |
|---|---|
| Titane | 15% environ |
| Aluminium | 25% environ |
| Oxygène | 47% environ |
| Azote | 13% environ |

Cette analyse montre bien qu'aucun autre élément chimique n'est présent dans cette couche, du moins pas en quantité telle qu'il puisse être décelé.

L'étude de la structure physique de la couche indique que celle-ci ressemble à une céramique comportant une phase amorphe transparente et isolante dans laquelle sont dispersées de très nombreuses inclusions de très petite taille qui sont responsables de la couleur noire de la couche et de sa conductibilité. Les dimensions de ces inclusions et les distances qui les séparent étant de l'ordre de grandeur du nanomètre, il n'a pas encore été possible de déterminer leur composition chimique et celle de la phase amorphe.

Comme cela a été déjà mentionné, cette couche est opaque, de sorte que la couleur du substrat sur lequel elle est déposée n'influence absolument pas sa propre couleur.

L'analyse chromatique de la couche déposée dans les conditions ci-dessus, de la manière prescrite par la Commission Internationale de l'Eclairage, a donné les résultats suivants:
L* = 35 à 41;
a* = 1,7 à 2,1;
b* = 0,7 à 2,7.
Ces valeurs sont celles d'une couche d'un beau noir profond et brillant.

En outre, la couche ainsi obtenue a été soumise à des essais d'usure et d'arrachage qui ont donné d'excellents résultats.

Le procédé selon l'invention a également été utilisé pour déposer des couches noires sur des substrats autres que l'acier inoxydable et/ou en utilisant des cibles préparées selon une autre des méthodes décrites ci-dessus. Dans tous les cas, les résultats ont été semblables à ceux qui ont été mentionnés ci-dessus.

## Revendications

1. Procédé de dépôt d'un revêtement de couleur noire sur un substrat, caractérisé par le fait qu'il comprend la préparation d'une matière comportant du titane, de l'aluminium, de l'oxygène et de l'azote et une opération de pulvérisation cathodique utilisant une cible en ladite matière, ladite pulvérisation cathodique étant réalisée en présence dudit substrat et sous une atmosphère de gaz non réactif.

2. Procédé selon la revendication 1, caractérisé par le fait que ladite préparation de ladite matière comprend le mélange d'une poudre d'oxyde de titane TiO2 et d'une poudre de nitrure d'aluminium AlN dans un rapport molaire de 1,5 TiO2 pour 2 AlN, et le frittage desdites poudres ainsi mélangées.

3. Procédé selon la revendication 1, caractérisé par le fait que ladite préparation de ladite matière comprend le mélange d'une poudre de nitrure de titane TiN et d'une poudre d'oxyde d'aluminium Al2O3 dans un rapport molaire de 1,5 TiN pour 1 Al2O3, et le frittage desdites poudres ainsi mélangées.

4. Procédé selon l'une des revendications 2 ou 3, caractérisé par le fait que ledit frittage est réalisé en soumettant lesdites poudres mélangées à une température de 1'400°C environ et à une pression de 45 Mégapascals environ pendant une heure environ.

5. Procédé selon la revendication 1, caractérisé par le fait que ladite préparation de ladite matière comprend le mélange d'une poudre d'oxyde de titane TiO2 et d'une poudre de nitrure d'aluminium AlN dans un rapport molaire de 1,5 TiO2 pour 2 AlN, et la compression à froid desdites poudres ainsi mélangées.

6. Procédé selon l'une quelconque des revendications 1 à 5, caractérisé par le fait que ledit gaz non réactif est de l'argon.

7. Revêtement de couleur noire disposé sur un substrat, caractérisé par le fait qu'il comporte du titane, de l'aluminium, de l'oxygène et de l'azote.

8. Revêtement selon la revendication 7, caractérisé par le fait que les concentrations atomiques du titane, de l'aluminium, de l'oxygène et de l'azote sont les suivantes :
| | | | |
|---|---|---|---|
| Titane | 15% environ | Aluminium | 25% environ |
| Oxygène | 47% environ | Azote | 13% environ |

## Claims

1. Process for depositing a black-coloured coating on a substrate, characterized by the fact that it comprises the preparation of a material containing titanium, aluminium, oxygen and nitrogen and a cathodic sputtering operation using a target of said material, said cathodic sputtering being effected in the presence of said substrate and in an inert gas atmosphere.

2. Process according to claim 1, characterized by the fact that said preparation of said material comprises mixing titanium oxide TiO2 powder and aluminium nitride A1N powder in a molar ratio of 1.5 parts TiO2 to 2 parts A1N and sintering so mixed powders.

3. Process according to claim 1, characterized by the fact that said preparation of said material comprises mixing titanium nitride TiN powder and aluminium oxide Al2O3 powder in a molar ratio of 1.5 parts Tin to 1 part Al2O3 and sintering so mixed powders.

4. Process according to one of claims 2 or 3, characterized by the fact that said sintering is conducted by subjecting said mixed powders to a temperature of about 1,400°C and a pressure of about 45 megapascals for about one hour.

5. Process according to claim 1, characterized by the fact that said preparation of said material comprises mixing titanium oxide TiO2 powder and aluminium nitride A1N powder in a molar ratio of 1.5 parts TiO2 to 2 parts A1N and cold compressing so mixed powders.

6. Process according to any one of claims 1 or 5, characterized by the fact that said inert gas is argon.

7. Black-coloured coating deposited on a substrate, characterized by the fact that said coating contains titanium, aluminium, oxygen and nitrogen.

8. Coating according to claim 7, characterized by the fact that the atomic concentrations of titanium, aluminium, oxygen and nitrogen are as follows :
| | | | |
|---|---|---|---|
| titanium | 15 % approx. | aluminium | 25 % approx. |
| oxygen | 47 % approx. | nitrogen | 13 % approx. |

## Patentansprüche

1. Verfahren Zum Aufbringen einer Beschichtung schwarzer Farbe auf ein Substrat, dadurch gekennzeichnet, daß es die Vorbereitung eines Materials umfaßt, umfassend Titan, Aluminium, Sauerstoff und Stickstoff, sowie eine Kathodenzerstäubungsoperation umfaßt unter Verwendung eines Targets aus dem genannten Material, welche Kathodenzerstäubung bei Gegenwart des genannten Substrats und unter einer Atmosphäre von nichtreaktivem Gas realisiert wird.

2. Verfahren nach Anspruch 1, dadurch gekennzeichnet, daß die Vorbereitung des genannten Materials das Mischen eines Pulvers ausTitanoxid TiO2 und eines Pulvers aus Aluminiumnitrit A1N in einemmolaren Verhältnis von 1,5 TiO2 auf 2 A1N und das Sintern der so gemischten Pulver umfaßt.

3. Verfahren nach Anspruch 1, dadurch gekennzeichnet, daß die Vorbereitung des genannten Materials das Mischen eines Pulvers aus Titannitrit TiN und eines Pulvers aus Aluminiumoxid Al2O3 in einem molaren Verhältnis von 1,5 TiN auf 1 Al2O3 und das Sintern der so gemischten Pulver umfaßt.

4. Verfahren nach einem der Ansprüche 2 oder 3, dadurch gekennzeichnet, daß das Sintern realisiert wird, indem die gemischten Pulver einer Temperatur von etwa 1.400°C und einem Druck von etwa 45 Megapascal während etwa einer Stunde ausgesetzt werden.

5. Verfahren nach Anspruch 1, dadurch gekennzeichnet, daß die Vorbereitung des genannten Materials das Mischen eines Pulvers aus Titanoxid TiO2 und eines Pulvers aus Aluminiunitrit A1N in einem molaren Verhältnis von 1,5 TiO2 auf 2 A1N und die Kaltverpressung der so gemischten Pulver umfaßt.

6. Verfahren nach einem der Ansprüche 1 bis 5, dadurch gekennzeichnet, daß das nichtreaktive Gas Argon ist.

7. Beschichtung schwarzer Farbe auf einem Substrat, dadurch gekennzeichnet, daß sie Titan, Aluminium, Sauerstoff und Stickstoff umfaßt.

8. Beschichtung nach Anspruch 7, dadurch gekennzeichnet, daß die atomaren Konzentrationen an Titan, Aluminium, Sauerstoff und Stickstoff die folgenden sind:
| | | | |
|---|---|---|---|
| Titan: | etwa 15% | Aluminium: | etwa 25% |
| Sauerstoff: | etwa 47% | Stickstoff: | etwa 13% |
